# EUROPEAN PATENT APPLICATION

(11) **EP 4 697 605 A1**
(43) Date of publication of application: **18.02.2026**
(21) Application number: 25187192.7
(22) Date of filing: 03.07.2025
(51) Int. Cl.: H04B 1/00

(54) **ACTIVE TUNABLE MULTIBAND FILTER CIRCUITRY**

(30) Priority: 14.08.2024 US 202418805377; 14.08.2024 US 202418805380
(71) Applicant: Apple Inc., Cupertino, CA 95014 (US)
(72) Inventor: HENZLER, Stephan, Munich (DE); KRUEGER, Roland, Egmating (DE); VAZNY, Rastislav, Saratoga (US)
(74) Representative: COPA Copenhagen Patents

(57) **Abstract**

Wireless circuitry can include a first filter circuit configured to output signals in a first frequency range, a second filter circuit configured to output signals in a second frequency range different than the first frequency range, and a signal combiner having a first input coupled to the first filter circuit and having a second input coupled to the second filter circuit. The wireless circuitry can further include a first switchable impedance matching circuit coupled between an antenna and the first filter circuit and a second switchable impedance matching circuit coupled between the antenna and the second filter circuit. The first and second filter circuits can be active filters such as lowpass-to-bandpass conversion filters operable in different frequency bands.

## Description

This application claims priority to U.S. Patent Application No. 18/805,380, filed August 14, 2025, and U.S. Patent Application No. 18/805,377, filed August 14, 2025, which are hereby incorporated by reference herein in their entireties.

### Field

This disclosure relates generally to electronic devices and, more particularly, to electronic devices with wireless communications circuitry.

### Background

Electronic devices can be provided with wireless communications capabilities. An electronic device with wireless communications capabilities has wireless communications circuitry with one or more antennas. Wireless transceiver circuitry in the wireless communications circuitry uses the antennas to transmit and receive radio-frequency signals.

Radio-frequency signals received by an antenna can be fed through acoustic filters to corresponding low noise amplifiers, which are configured to amplify low power analog signals to higher power signals for ease of processing at a receiver. The acoustic filters are passive bandpass filters that are costly to implement. It can be challenging to design filter and amplifier circuitry for the receiver.

### Summary

An aspect of the disclosure provides circuitry that includes a first filter circuit configured to output signals in a first frequency range, a second filter circuit configured to output signals in a second frequency range different than the first frequency range, a signal combiner having a first input coupled to the first filter circuit and having a second input coupled to the second filter circuit, and a first switchable matching circuit coupled to an input of the first filter circuit. The circuitry can further include a second switchable matching circuit coupled to an input of the second filter circuit and a frequency shifting circuit coupled between the second filter circuit and the second input of the signal combiner. The first filter circuit can be a first lowpass-to-bandpass conversion filter, whereas the second filter circuit can be a second lowpass-to-bandpass conversion filter. The circuitry can further include a control circuit for configuring the first and second switchable matching circuits to provide a target impedance to an antenna in a first mode, the target impedance to the antenna in a second mode different than the first mode, and the target impedance to the antenna in a third mode different than the first and second modes.

An aspect of the disclosure provides circuitry that includes a first impedance matching circuit configured to receive a radio-frequency signal, a second impedance matching circuit configured to receive the radio-frequency signal, and a combiner having a first input coupled to the first impedance matching circuit and having a second input coupled to the second impedance matching circuit. The first input of the combiner can be configured to receive a first signal associated with a first frequency band, and the second input of the combiner can be configured to receive a second signal associated with a second frequency band different than the first frequency band. The circuitry can further include a first lowpass-to-bandpass conversion filter coupled between the first impedance matching circuit and the first input of the combiner and a second lowpass-to-bandpass conversion filter coupled between the second impedance matching circuit and the second input of the combiner.

An aspect of the disclosure provides circuitry that includes a first switchable matching circuit selectively coupled to an antenna, a second switchable matching circuit selectively coupled to the antenna, a first active filter coupled to the first switchable matching circuit, a second active filter coupled to the second switchable matching circuit, a signal combiner having a first terminal coupled to the first active filter, a second terminal coupled to the second active filter, and a third terminal, and a radio-frequency amplifier coupled to the third terminal of the signal combiner.

### Brief Description of the Drawings

FIG. 1 is a diagram of an illustrative electronic device having wireless circuitry in accordance with some embodiments.
FIG. 2 is a diagram of illustrative wireless circuitry having radio-frequency amplifiers and filters in accordance with some embodiments.
FIG. 3 is a diagram of a receive path that includes active tunable multiband filter circuitry in accordance with some embodiments.
FIG. 4 is diagram showing an illustrative implementation of active tunable multiband filter circuitry coupled to a radio-frequency amplifier in accordance with some embodiments.
FIG. 5 is a diagram illustrating various filter transfer functions in accordance with some embodiments.
FIG. 6 is a circuit diagram of an illustrative lowpass-to-bandpass conversion filter in accordance with some embodiments.
FIG. 7 is a table showing various states for operating the wireless circuitry of the type shown in FIGS. 1-6 in accordance with some embodiments.
FIG. 8 is a flowchart of illustrative steps for operating the wireless circuitry of the type shown in FIGS. 1-7 in accordance with some embodiments.

### Detailed Description

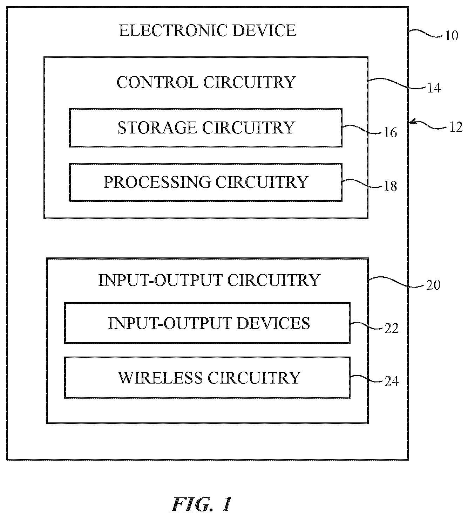

An electronic device such as device 10 of FIG. 1 may be provided with wireless circuitry. The wireless circuitry can include multiple filter paths coupled between an antenna and a single receive path. The multiple filter paths can include multiple switchable matching circuits, multiple lowpass-to-bandpass conversion filters, and a combiner circuit. A first of the filters can be configured to output signals in a first band or range of frequencies, whereas a second of the filters can be configured to output signals in a second band or range of frequencies. The multiple filter paths can be operable in at least a first mode during which only a first of the matching circuits and the first filter are activated, a second mode during which only a second of the matching circuits and the second filter are activated, and a third mode during which the first and second matching circuits and the first and second filters are all activated. An impedance seen by the antenna can be the same in all three modes. Configured and operated in this way, radio-frequency signals received by the antenna via multiple radio-frequency bands can be combined into a single receive path, resulting in a substantial cost reduction for the corresponding transceiver design.

Electronic device 10 of FIG. 1 may be a computing device such as a laptop computer, a desktop computer, a computer monitor containing an embedded computer, a tablet computer, a cellular telephone, a media player, or other handheld or portable electronic device, a smaller device such as a wristwatch device, a pendant device, a headphone or earpiece device, a device embedded in eyeglasses or other equipment worn on a user's head, or other wearable or miniature device, a television, a computer display that does not contain an embedded computer, a gaming device, a navigation device, an embedded system such as a system in which electronic equipment with a display is mounted in a kiosk or automobile, a wireless internet-connected voice-controlled speaker, a home entertainment device, a remote control device, a gaming controller, a peripheral user input device, a wireless base station or access point, equipment that implements the functionality of two or more of these devices, or other electronic equipment.

As shown in the functional block diagram of FIG. 1, device 10 may include components located on or within an electronic device housing such as housing 12. Housing 12, which may sometimes be referred to as a case, may be formed from plastic, glass, ceramics, fiber composites, metal (e.g., stainless steel, aluminum, metal alloys, etc.), other suitable materials, or a combination of these materials. In some embodiments, parts or all of housing 12 may be formed from dielectric or other low-conductivity material (e.g., glass, ceramic, plastic, sapphire, etc.). In other embodiments, housing 12 or at least some of the structures that make up housing 12 may be formed from metal elements.

Device 10 may include control circuitry 14. Control circuitry 14 may include storage such as storage circuitry 16. Storage circuitry 16 may include hard disk drive storage, nonvolatile memory (e.g., flash memory or other electrically-programmable-read-only memory configured to form a solid-state drive), volatile memory (e.g., static or dynamic random-access-memory), etc. Storage circuitry 16 may include storage that is integrated within device 10 and/or removable storage media.

Control circuitry 14 may include processing circuitry such as processing circuitry 18. Processing circuitry 18 may be used to control the operation of device 10. Processing circuitry 18 may include on one or more microprocessors, microcontrollers, digital signal processors, host processors, baseband processor integrated circuits, application specific integrated circuits, central processing units (CPUs), etc. Control circuitry 14 may be configured to perform operations in device 10 using hardware (e.g., dedicated hardware or circuitry), firmware, and/or software. Software code for performing operations in device 10 may be stored on storage circuitry 16 (e.g., storage circuitry 16 may include non-transitory (tangible) computer readable storage media that stores the software code). The software code may sometimes be referred to as program instructions, software, data, instructions, or code. Software code stored on storage circuitry 16 may be executed by processing circuitry 18.

Control circuitry 14 may be used to run software on device 10 such as satellite navigation applications, internet browsing applications, voice-over-internet-protocol (VOIP) telephone call applications, email applications, media playback applications, operating system functions, etc. To support interactions with external equipment, control circuitry 14 may be used in implementing communications protocols. Communications protocols that may be implemented using control circuitry 14 include internet protocols, wireless local area network (WLAN) protocols (e.g., IEEE 802.11 protocols - sometimes referred to as Wi-Fi^{®}), protocols for other short-range wireless communications links such as the Bluetooth^{®} protocol or other wireless personal area network (WPAN) protocols, IEEE 802.11ad protocols (e.g., ultra-wideband protocols), cellular telephone protocols (e.g., 3G protocols, 4G (LTE) protocols, 5G protocols, etc.), antenna diversity protocols, satellite navigation system protocols (e.g., global positioning system (GPS) protocols, global navigation satellite system (GLONASS) protocols, etc.), antenna-based spatial ranging protocols (e.g., radio detection and ranging (RADAR) protocols or other desired range detection protocols for signals conveyed at millimeter and centimeter wave frequencies), or any other desired communications protocols. Each communications protocol may be associated with a corresponding radio access technology (RAT) that specifies the physical connection methodology used in implementing the protocol.

Device 10 may include input-output circuitry 20. Input-output circuitry 20 may include input-output devices 22. Input-output devices 22 may be used to allow data to be supplied to device 10 and to allow data to be provided from device 10 to external devices. Input-output devices 22 may include user interface devices, data port devices, and other input-output components. For example, input-output devices 22 may include touch sensors, displays (e.g., touch-sensitive and/or force-sensitive displays), light-emitting components such as displays without touch sensor capabilities, buttons (mechanical, capacitive, optical, etc.), scrolling wheels, touch pads, key pads, keyboards, microphones, cameras, buttons, speakers, status indicators, audio jacks and other audio port components, digital data port devices, motion sensors (accelerometers, gyroscopes, and/or compasses that detect motion), capacitance sensors, proximity sensors, magnetic sensors, force sensors (e.g., force sensors coupled to a display to detect pressure applied to the display), etc. In some configurations, keyboards, headphones, displays, pointing devices such as trackpads, mice, and joysticks, and other input-output devices may be coupled to device 10 using wired or wireless connections (e.g., some of input-output devices 22 may be peripherals that are coupled to a main processing unit or other portion of device 10 via a wired or wireless link).

Input-output circuitry 20 may include wireless circuitry 24 to support wireless communications. Wireless circuitry 24 (sometimes referred to herein as wireless communications circuitry 24) may include one or more antennas. Wireless circuitry 24 may also include baseband processor circuitry, transceiver circuitry, amplifier circuitry, filter circuitry, switching circuitry, radio-frequency transmission lines, and/or any other circuitry for transmitting and/or receiving radio-frequency signals using the antenna(s).

Wireless circuitry 24 may transmit and/or receive radio-frequency signals within a corresponding frequency band at radio frequencies (sometimes referred to herein as a communications band or simply as a "band"). The frequency bands handled by wireless circuitry 24 may include wireless local area network (WLAN) frequency bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network (WPAN) frequency bands such as the 2.4 GHz Bluetooth^{®} band or other WPAN communications bands, cellular telephone frequency bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), other centimeter or millimeter wave frequency bands between 10-300 GHz, near-field communications frequency bands (e.g., at 13.56 MHz), satellite navigation frequency bands (e.g., a GPS band from 1565 to 1610 MHz, a Global Navigation Satellite System (GLONASS) band, a BeiDou Navigation Satellite System (BDS) band, etc.), ultra-wideband (UWB) frequency bands that operate under the IEEE 802.15.4 protocol and/or other ultra-wideband communications protocols, communications bands under the family of 3GPP wireless communications standards, communications bands under the IEEE 802.XX family of standards, and/or any other desired frequency bands of interest.

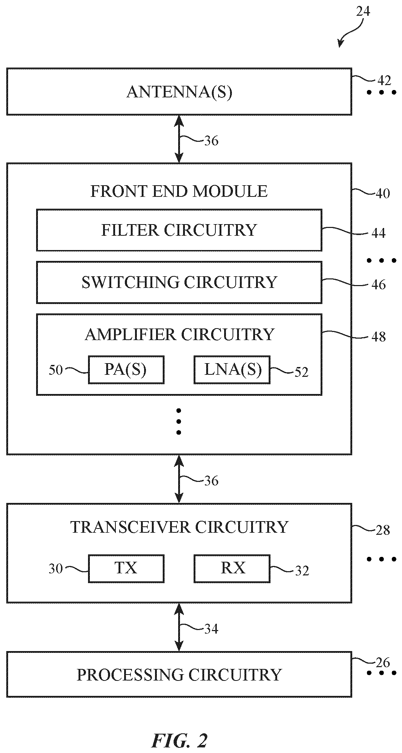

FIG. 2 is a diagram showing illustrative components within wireless circuitry 24. As shown in FIG. 2, wireless circuitry 24 may include processing circuitry such as processing circuitry 26, radio-frequency (RF) transceiver circuitry such as radio-frequency transceiver 28, radio-frequency front end circuitry such as radio-frequency front end module (FEM) 40, and antenna(s) 42. Processing circuitry 26 may include one or more baseband processor, application processor, general purpose processor, microprocessor, microcontroller, digital signal processor, host processor, application specific signal processing hardware, or other type of processor. Processing circuitry 26 may be coupled to transceiver 28 over path 34. Transceiver 28 may be coupled to antenna 42 via radio-frequency transmission line path 36. Radio-frequency front end module 40 may be disposed on radio-frequency transmission line path 36 between transceiver 28 and antenna 42.

In the example of FIG. 2, wireless circuitry 24 is illustrated as including only one instance of processing circuitry 26, a single transceiver 28, a single front end module 40, and a single antenna 42 for the sake of clarity. In general, wireless circuitry 24 may include any desired number of processing circuitry 26, any desired number of transceivers 28, any desired number of front end modules 40, and any desired number of antennas 42. Each processing circuitry 26 may be coupled to one or more transceiver 28 over respective paths 34. Each transceiver 28 may include a transmitter circuit 30 configured to output uplink signals to antenna 42, may include a receiver circuit 32 configured to receive downlink signals from antenna 42, and may be coupled to one or more antennas 42 over respective radio-frequency transmission line paths 36. Each radio-frequency transmission line path 36 may have a respective front end module 40 disposed thereon. If desired, two or more front end modules 40 may be disposed on the same radio-frequency transmission line path 36. If desired, one or more of the radio-frequency transmission line paths 36 in wireless circuitry 24 may be implemented without any front end module disposed thereon.

Radio-frequency transmission line path 36 may be coupled to an antenna feed on antenna 42. The antenna feed may, for example, include a positive antenna feed terminal and a ground antenna feed terminal. Radio-frequency transmission line path 36 may have a positive transmission line signal path such that is coupled to the positive antenna feed terminal on antenna 42. Radio-frequency transmission line path 36 may have a ground transmission line signal path that is coupled to the ground antenna feed terminal on antenna 42. This example is merely illustrative and, in general, antennas 42 may be fed using any desired antenna feeding scheme. If desired, antenna 42 may have multiple antenna feeds that are coupled to one or more radio-frequency transmission line paths 36.

Radio-frequency transmission line path 36 may include transmission lines that are used to route radio-frequency antenna signals within device 10 (FIG. 1). Transmission lines in device 10 may include coaxial cables, microstrip transmission lines, stripline transmission lines, edge-coupled microstrip transmission lines, edge-coupled stripline transmission lines, transmission lines formed from combinations of transmission lines of these types, etc. Transmission lines in device 10 such as transmission lines in radio-frequency transmission line path 36 may be integrated into rigid and/or flexible printed circuit boards.

In performing wireless transmission, processor 26 may provide transmit signals (e.g., digital or baseband signals) to transceiver 28 over path 34. Transceiver 28 may further include circuitry for converting the transmit (baseband) signals received from processor 26 into corresponding radio-frequency signals. For example, transceiver circuitry 28 may include mixer circuitry for up-converting (or modulating) the transmit (baseband) signals to radio frequencies prior to transmission over antenna 42. The example of FIG. 2 in which processor 26 communicates with transceiver 28 is merely illustrative. In general, transceiver 28 may communicate with a baseband processor, an application processor, general purpose processor, a microcontroller, a microprocessor, or one or more processors within circuitry 18. Transceiver circuitry 28 may also include digital-to-analog converter (DAC) and/or analog-to-digital converter (ADC) circuitry for converting signals between digital and analog domains. Transceiver 28 may use transmitter (TX) 30 to transmit the radio-frequency signals over antenna 42 via radio-frequency transmission line path 36 and front end module 40. Antenna 42 may transmit the radio-frequency signals to external wireless equipment by radiating the radio-frequency signals into free space.

In performing wireless reception, antenna 42 may receive radio-frequency signals from the external wireless equipment. The received radio-frequency signals may be conveyed to transceiver 28 via radio-frequency transmission line path 36 and front end module 40. Transceiver 28 may include circuitry such as receiver (RX) 32 for receiving signals from front end module 40 and for converting the received radio-frequency signals into corresponding baseband signals. For example, transceiver 28 may include mixer circuitry for down-converting (or demodulating) the received radio-frequency signals to baseband frequencies prior to conveying the received signals to processor 26 over path 34.

Front end module (FEM) 40 may include radio-frequency front end circuitry that operates on the radio-frequency signals conveyed (transmitted and/or received) over radio-frequency transmission line path 36. FEM 40 may, for example, include front end module (FEM) components such as radio-frequency filter circuitry 44 (e.g., low pass filters, high pass filters, notch filters, band pass filters, multiplexing circuitry, duplexer circuitry, diplexer circuitry, triplexer circuitry, etc.), switching circuitry 46 (e.g., one or more radio-frequency switches), radio-frequency amplifier circuitry 48 (e.g., one or more power amplifier circuits 50 and/or one or more low-noise amplifier circuits 52), impedance matching circuitry (e.g., circuitry that helps to match the impedance of antenna 42 to the impedance of radio-frequency transmission line 36), antenna tuning circuitry (e.g., networks of capacitors, resistors, inductors, and/or switches that adjust the frequency response of antenna 42), radio-frequency coupler circuitry, charge pump circuitry, power management circuitry, digital control and interface circuitry, and/or any other desired circuitry that operates on the radio-frequency signals transmitted and/or received by antenna 42. Each of the front end module components may be mounted to a common (shared) substrate such as a rigid printed circuit board substrate or flexible printed circuit substrate. If desired, the various front end module components may also be integrated into a single integrated circuit chip. If desired, amplifier circuitry 48 and/or other components in front end 40 such as filter circuitry 44 may also be implemented as part of transceiver circuitry 28.

Filter circuitry 44, switching circuitry 46, amplifier circuitry 48, and other circuitry may be disposed along radio-frequency transmission line path 36, may be incorporated into FEM 40, and/or may be incorporated into antenna 42 (e.g., to support antenna tuning, to support operation in desired frequency bands, etc.). These components, sometimes referred to herein as antenna tuning components, may be adjusted (e.g., using control circuitry 14) to adjust the frequency response and wireless performance of antenna 42 over time.

Transceiver 28 may be separate from front end module 40. For example, transceiver 28 may be formed on another substrate such as the main logic board of device 10, a rigid printed circuit board, or flexible printed circuit that is not a part of front end module 40. While control circuitry 14 is shown separately from wireless circuitry 24 in the example of FIG. 1 for the sake of clarity, wireless circuitry 24 may include processing circuitry that forms a part of processing circuitry 18 and/or storage circuitry that forms a part of storage circuitry 16 of control circuitry 14 (e.g., portions of control circuitry 14 may be implemented on wireless circuitry 24). As an example, processor 26 and/or portions of transceiver 28 (e.g., a host processor on transceiver 28) may form a part of control circuitry 14. Control circuitry 14 (e.g., portions of control circuitry 14 formed on processor 26, portions of control circuitry 14 formed on transceiver 28, and/or portions of control circuitry 14 that are separate from wireless circuitry 24) may provide control signals (e.g., over one or more control paths in device 10) that control the operation of front end module 40.

Transceiver circuitry 28 may include wireless local area network transceiver circuitry that handles WLAN communications bands (e.g., Wi-Fi^{®} (IEEE 802.11) or other WLAN communications bands) such as a 2.4 GHz WLAN band (e.g., from 2400 to 2480 MHz), a 5 GHz WLAN band (e.g., from 5180 to 5825 MHz), a Wi-Fi^{®} 6E band (e.g., from 5925-7125 MHz), and/or other Wi-Fi^{®} bands (e.g., from 1875-5160 MHz), wireless personal area network transceiver circuitry that handles the 2.4 GHz Bluetooth^{®} band or other WPAN communications bands, cellular telephone transceiver circuitry that handles cellular telephone bands (e.g., bands from about 600 MHz to about 5 GHz, 3G bands, 4G LTE bands, 5G New Radio Frequency Range 1 (FR1) bands below 10 GHz, 5G New Radio Frequency Range 2 (FR2) bands between 20 and 60 GHz, etc.), near-field communications (NFC) transceiver circuitry that handles near-field communications bands (e.g., at 13.56 MHz), satellite navigation receiver circuitry that handles satellite navigation bands (e.g., a GPS band from 1565 to 1610 MHz, a Global Navigation Satellite System (GLONASS) band, a BeiDou Navigation Satellite System (BDS) band, etc.), ultra-wideband (UWB) transceiver circuitry that handles communications using the IEEE 802.15.4 protocol and/or other ultra-wideband communications protocols, and/or any other desired radio-frequency transceiver circuitry for covering any other desired communications bands of interest.

Wireless circuitry 24 may include one or more antennas such as antenna 42. Antenna 42 may be formed using any desired antenna structures. For example, antenna 42 may be an antenna with a resonating element that is formed from loop antenna structures, patch antenna structures, inverted-F antenna structures, slot antenna structures, planar inverted-F antenna structures, helical antenna structures, monopole antennas, dipoles, hybrids of these designs, etc. Two or more antennas 42 may be arranged into one or more phased antenna arrays (e.g., for conveying radio-frequency signals at millimeter wave frequencies). Parasitic elements may be included in antenna 42 to adjust antenna performance. Antenna 42 may be provided with a conductive cavity that backs the antenna resonating element of antenna 42 (e.g., antenna 42 may be a cavity-backed antenna such as a cavity-backed slot antenna).

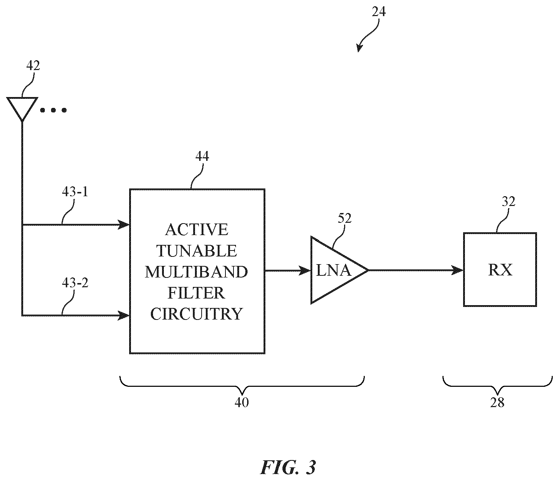

FIG. 3 is a diagram of a receive path within wireless circuitry 24. As shown in FIG. 3, wireless circuitry 24 can include filter circuitry such as filter circuitry 44 coupled to one or more antennas via at least a first signal path 43-1 and a second signal path 43-2. Filter circuitry 44 may be an "active" filter, which refers to a filter circuit that can include not only passive electronic components but also active electric components such as transistors. Filter circuitry 44 is also tunable, which refers to its ability to operate in a plurality of different modes. Tunable filter circuitry 44 may be operable in two or more modes, three or more modes, four or more modes, or other suitable number of operating modes. Filter circuitry 44 may also be a "multiband" filter, which refers to its ability to combine or merge signals from more than one radio-frequency band (e.g., to combine signals in different frequency ranges). Multiband filter circuitry 44 may be operable to merge radio-frequency signals from two or more frequency bands, three or more frequency bands, four or more frequency bands, or other suitable number of frequency bands. Filter circuitry 44 can thus sometimes be referred to as active tunable multiband filter circuitry 44.

Active tunable multiband filter circuitry 44 can be coupled to a radio-frequency amplifier. In the example of FGI. 3, filter circuitry 44 can have an output coupled to radio-frequency amplifier 52 (e.g., a low noise amplifier in the receive path). Filter circuitry 44 and amplifier 52 can be part of front end module 40. Front end module 40 can optionally include other front end components not shown in FIG. 3 (e.g., module 40 can include one or more components coupled between antenna 42 and filter 44, one or more components coupled between filter 44 and amplifier 52, and one or more components coupled at the output of amplifier 52). Having only a single receiving amplifier 52 to receive multiband signals that are combined at filter circuitry 44 can be technically advantageous and beneficial to simplify the ensuing transceiver design. Amplifier 52 can have an output coupled to a corresponding receiver 32. Receiver 32 can be part of transceiver 28 (see also FIG. 2). Receiver 32 can, for example, include one or more downconverters (e.g., mixers) for demodulating the received radio-frequency signals and one or more data converters for converting the analog radio-frequency signals into digital signals.

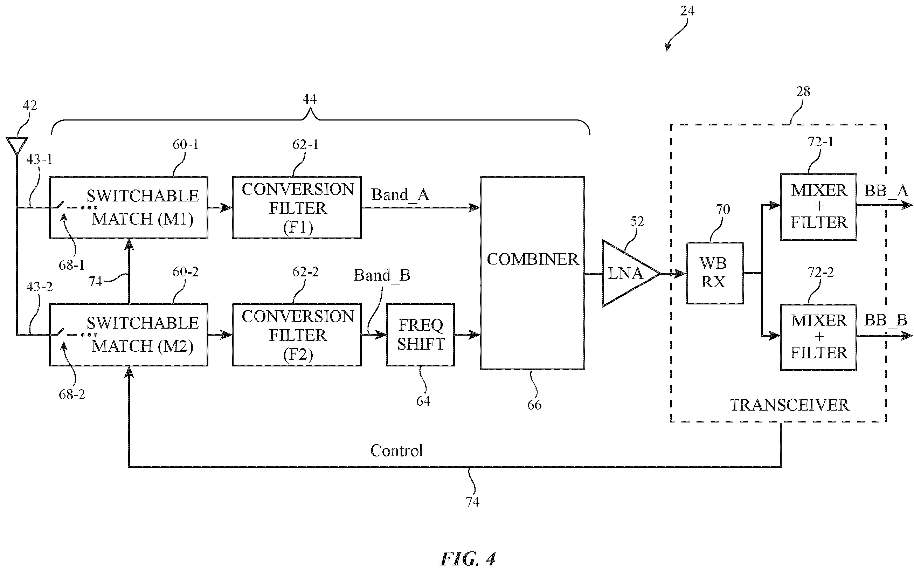

FIG. 4 is diagram showing an illustrative implementation of active tunable multiband filter circuitry 44. As shown in FIG. 4, filter circuitry 44 may include a first switchable matching circuit 60-1 (sometimes referred to herein as "M1"), a second switchable matching circuit 60-2 (sometimes referred to herein as "M2"), a first filter 62-1 (sometimes referred to herein as "F1"), a second filter 62-2 (sometimes referred to herein as "F2"), and a signal combining circuit such as combiner 66. First switchable matching circuit 60-1 may be an impedance matching circuit that can be selectively coupled to antenna 42 via signal path 43-1 and a first switch 68-1 and can be configured to provide one or more impedance values to match with the impedance of antenna 42. Switch 68-1 can be activated to connect matching circuit 60-1 to antenna signal path 43-1 and can be deactivated to disconnect matching circuit 60-1 from antenna 42.

The term "activate" with respect to a switch (or transistor) may refer to or be defined herein as an action that places the switch in an "on" or low-impedance state such that the two terminals of the switch are electrically connected to conduct current. Activating a switch can sometimes be referred to as turning on or closing a switch. The term "deactivate" with respect to a switch (or transistor) may refer to or be defined herein as an action that places the switch in an "off" or high-impedance state such that the two terminals of the switch/transistor are electrically disconnected with minimal leakage current. Deactivating a switch can sometimes be referred to as turning off or opening a switch.

Similarly, second switchable matching circuit 60-2 may be an impedance matching circuit that can be selectively coupled to antenna 42 via signal path 43-2 and a second switch 68-2 and can be configured to provide one or more impedance values to match with antenna 42. Switch 68-2 can be activated to connect matching circuit 60-2 to antenna signal path 43-2 and can be deactivated to disconnect matching circuit 60-2 from antenna 42. As examples, each of impedance matching circuits 60-1 and 60-2 can each (individually) be configured to provide an impedance of 50 Ohms, 100 Ohms, 75 Ohms, 50-100 Ohms, less than 50 Ohms, greater than 50 Ohms, less than 100 Ohms, greater than 100 Ohms, and/or other impedance values. The state of switches 68-1 and 68-2 and the amount of impedance provided by matching circuits 60-1 and 60-2 can be adjusted based on control signals conveyed over path 74 from transceiver 28. Transceiver 28 can include one or more control circuits (control circuitry) configured to output the control signals for selectively activating and deactivating switches 68-1 and 68-2 and for selectively configuring each of matching circuits 60-1 and 60-2 to provide the same or different impedance values.

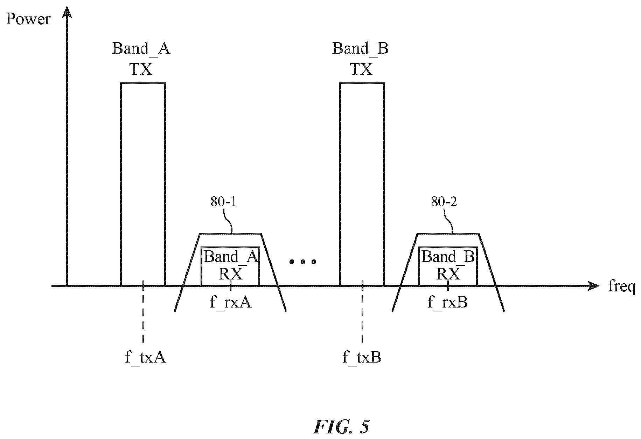

First filter 62-1 may have an input coupled to switchable impedance matching circuit 60-1. Filter 62-1 may be a lowpass-to-passband conversion filter (e.g., a filter configured to provide a lowpass to bandpass conversion function). Filter 62-1 can, for example, be implemented as a first N-path filter. Filter 62-1 may be configured to provide a filter response or transfer function illustrated in FIG. 5. FIG. 5 plots signal power as a function of frequency. In the example of FIG. 5, radio-frequency signals can be transmitted in a first frequency band ("Band_A") centered around frequency f_txA. Radio-frequency signals associated with Band_A can be received at frequency f_rxA, which is offset from frequency f_txA. Although frequency f_rxA is shown as being greater than frequency f_txA in the example of FIG. 5, frequency f_rxA can alternatively be less than frequency f_txA.

It may be desirable to reduce/attenuate the transmit signal power at frequency f_txA before the antenna signal can be fed to the receive path. Thus, filter 62-1 can be configured to provide a filter transfer function illustrated by filter response 80-1. As shown in FIG. 5, filter response 80-1 can have a passband centered around frequency f_rxA while rejecting transmit signals at nearby frequency f_txA(e.g., by 30 dB or more). Referring back to FIG. 4, filter 62-1 can thus output receive signals associated with Band_A, sometimes also referred to as a first frequency or first frequency range. It is understood that filters are not perfect circuit components, so filter 62-1 can potentially output residual (trace) signals outside the first frequency range.

Similarly, second filter 62-2 may have an input coupled to switchable impedance matching circuit 60-2. Filter 62-2 may be a lowpass-to-passband conversion filter (e.g., a filter configured to provide a lowpass to bandpass conversion function). Filter 62-2 can, for example, be implemented as a second N-path filter. Filter 62-2 may be configured to provide a filter response or transfer function also illustrated in FIG. 5. In the example of FIG. 5, radio-frequency signals can additional be transmitted in a second frequency band ("Band_B") centered around frequency f_txB. Radio-frequency signals associated with Band_B can be received at frequency f_rxB, which is offset from frequency f_txB. Although frequency f_rxB is shown as being greater than frequency f_txB in the example of FIG. 5, frequency f_rxB can alternatively be less than frequency f_txB. Moreover, although frequencies f_txB and f_rxB are shown as being greater than frequencies f_txA and f_rxA, in the example of FIG. 5, frequencies f_txB and f_rxB can alternatively be less than frequencies f_txA and f_rxA.

It may be desirable to reduce/attenuate the transmit signal power at frequency f_txB before the antenna signal can be fed to the receive path. Thus, filter 62-2 can be configured to provide a filter transfer function illustrated by filter response 80-2. As shown in FIG. 5, filter response 80-2 can have a passband centered around frequency f_rxB while rejecting transmit signals at nearby frequency f_txB (e.g., by 30 dB or more). Referring back to FIG. 4, filter 62-2 can thus output receive signals associated with Band_B, sometimes also referred to as a second frequency (different than the first frequency) or a second frequency range (different than the first frequency range). Band_A and Band_B can, for example, be nonoverlapping frequency ranges. It is understood that filters are not perfect circuit components, so filter 62-2 can potentially output residual (trace) signals outside the second frequency range.

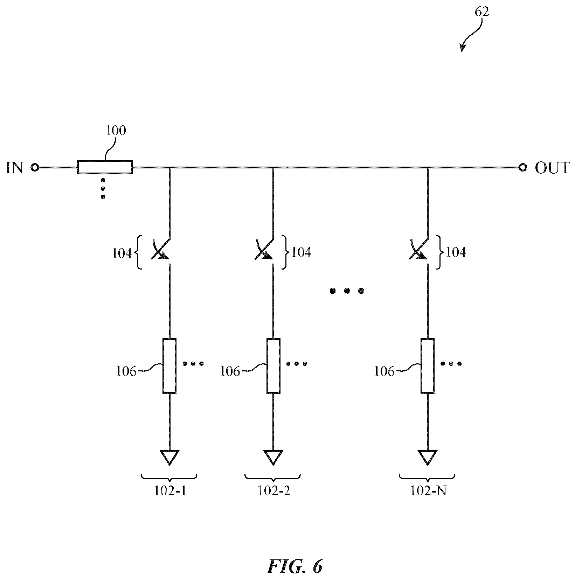

In accordance with some embodiments, filters 62-1 and 62-2 can be implemented as N-path filters. "N-path filters" can refer to and be defined herein as an active filter circuit with multiple switchable paths (see, e.g., FIG. 6). As shown in FIG. 6, N-path filter 62 can include an input terminal IN, an output terminal OUT, one or more passive components 100 coupled in series between the input and output terminals and N parallel paths 102-1, 102-2, .. . , and 102-N. The number N can be an integer greater than two, two to ten, 10-20, 20-30, 30-50, 50-100, greater than 100, 100-1000, greater than 1000, or other integer value. Each of the N parallel paths 102 can include one or more passive electrical components 106 coupled in series with a switch 104. Activating a switch 104 can switch into use the corresponding component 106, whereas deactivating a switch 104 can switch out of use the corresponding component 106. The various passive components 100 and 106 can represent one or more capacitors, one or more inductors, one or more resistors, other passive components, and/or optionally active electrical components. The N-path filter shown in FIG. 6 is exemplary. If desired, filters 62-1 and 62-2 can be implemented as other types of bandpass filter circuits.

Referring again back to FIG. 4, combiner 66 may have a first input coupled to filter 62-1 and a second input coupled to filter 62-2. The first input of combiner 66 may be configured to receive radio-frequency signals in Band_A, whereas the second input of combiner 66 may be configured to receive radio-frequency signals in Band_B. If desired, a frequency shifting circuit 64 can optionally be coupled between filter 62-2 and the second input of combiner 66, where frequency shifter 64 is configured to provide an amount of frequency shifting for reducing any frequency gap between the two receive bands Band_A and Band_B. Frequency shifter 64 can for example, be configured to shift the received signal from Band_B to a shifted frequency range Band_B' that is closer to Band_A. In other words, frequency shifter 64 can be configured to move the two frequency bands Band_A and Band_B closer to each other. Doing so can be technically advantageous and beneficial to minimize the bandwidth requirement of the following receiver. The example of FIG. 4 in which frequency shifter 64 is coupled between filter 62-2 and the second input of combiner 66 is illustrative. Alternatively, frequency shifter 64 can be coupled between filter 62-1 and the first input of combiner 66.

Combiner 66 can be configured to combine or merge the radio-frequency signals received at its two inputs (e.g., to combine the signals in two different radio-frequency bands or ranges) into a single multiband signal, assuming both receive paths are activated. In other words, combiner 66 can bring both filtered bands onto the same output signal line. However, if only the first receive path is activated (e.g., if only switchable matching circuit 60-1 is connected to antenna 42 while switchable matching circuit 60-2 is disconnected from antenna 42, then combiner 66 will simply pass through the signal received at its first input to its output. Conversely, if only the second receive path is activated (e.g., if only switchable matching circuit 60-2 is connected to antenna 42 while switchable matching circuit 60-1 is disconnected from antenna 42, then combiner 66 will simply pass through the signal received at its second input to its output).

Combiner 66 can have an output that is coupled to a single receiving radio-frequency amplifier 52. Amplifier 52 can be configured to amplify the received signals and to output corresponding amplified signals to transceiver 28. If desired, wireless circuitry 24 can optionally include one or more components (not shown) coupled between amplifier 52 and transceiver 28. Transceiver 28 can include a receiver circuit such as a wideband (WB) receiver 70. Wideband receiver 70 can be configured with a bandwidth that is wide enough to accommodate the two filtered frequency bands/ranges (e.g., receiver 70 has a bandwidth that covers both Band_A and optionally shifted Band_B'). Wideband receiver 70 can be configured to downconvert the combined signals from radio frequencies into baseband frequencies or an intermediate frequency (e.g., a frequency between radio-frequencies and baseband frequencies). Wideband receiver 70 can include one or more downconversion mixers, one or more filters, one or more analog-to-digital converters, etc.

Wideband receiver 70 can have an output that is coupled to a first mixer and filter circuit 72-1 and to a second mixer and filter circuit 72-2. The first mixer and filter circuit 72-1 can have a bandwidth that is narrower than that of wideband receiver 70. Circuit 72-1 can include a first digital filter and a first mixer configured to demodulate signals either at an input of the first digital filter or at an output of the first digital filter (e.g., the first mixer can be coupled before or after the first digital filter). The first mixer and filter circuit 72-1 can thus be configured to output a corresponding first digital baseband signal BB_A that is downconverted from Band_A. The second mixer and filter circuit 72-2 can have a bandwidth that is narrower than that of wideband receiver 70. Circuit 72-2 can include a second digital filter and a second mixer configured to demodulate signals either at an input of the second digital filter or at an output of the second digital filter (e.g., the second mixer can be coupled before or after the second digital filter). The second mixer and filter circuit 72-2 can thus be configured to output a corresponding second digital baseband signal BB_B that is downconverted from Band_B or optionally Band_B' (if frequency shifter 64 is used). The baseband signals BB_A and BB_B can be conveyed to processing circuitry 26 (see, e.g., FIG. 2) for subsequent processing.

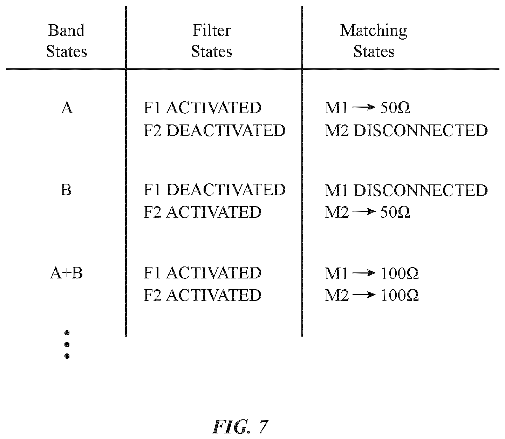

FIG. 7 is a table showing various states for operating wireless circuitry 24 of the type described in connection with FIGS. 1-6. As shown in FIG. 7, the wireless circuitry 24 can be configured to operate in at least three or more modes. In a first mode, wireless circuitry 24 can be configured to process only signals in Band_A (e.g., signals at a first frequency or in a first frequency range). In the first mode, the first lowpass-to-bandpass conversion filter 62-1 can be activated while the second lowpass-to-bandpass conversion filter 62-2 can be deactivated. In the first mode, the first matching circuit 60-1 can be switched into use while the second matching circuit 60-2 can be switched out of use (e.g., disconnected from the antenna). For example, the activated matching circuit 60-1 can be configured to provide a 50 Ohm impedance for the connected antenna.

In a second mode different than the first mode, wireless circuitry 24 can be configured to process only signals in Band_B or optionally Band_B' (e.g., signals at a second frequency or in a second frequency range). In the second mode, the second lowpass-to-bandpass conversion filter 62-2 can be activated while the first lowpass-to-bandpass conversion filter 62-1 is deactivated. In the second mode, the second matching circuit 60-2 can be switched into use while the first matching circuit 60-1 can be switched out of use (e.g., disconnected from the antenna). For example, the activated matching circuit 60-2 can be configured to provide a 50 Ohm impedance for the connected antenna.

In a third mode different than the first and second modes, wireless circuitry 24 can be configured to process signals in both Band_A and Band_B (or optionally Band_B'). In the third mode, the first lowpass-to-bandpass conversion filter 62-1 and the second lowpass-to-bandpass conversion filter 62-2 can be simultaneously activated. In the third mode, the first matching circuit 60-1 and the second matching circuit 60-2 can be switched into use and connected to the antenna. For example, the matching circuits 60-1 and 60-1 can each be configured to provide a 100 Ohm impedance, which collectively provides a combined 50 Ohm impedance for the connected antenna. Operated in this way, the wireless circuitry can present a constant target impedance (e.g., 50 Ohm as an example) for the antenna for each of the different modes, thus providing optimum power transfer of the receive path. The example of FIG. 7 in which the wireless circuitry is operable in at least three different modes is illustrative. If desired, the wireless circuitry can be configured to operate in four or more modes, five or more modes, five to ten different modes, or more than 10 modes for receiving signals associated with different sets of frequencies.

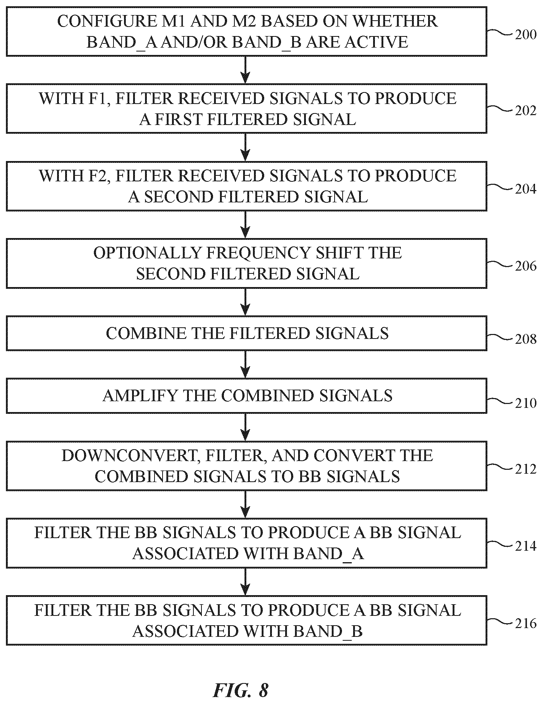

FIG. 8 is a flowchart of illustrative steps for operating wireless circuitry 24 of the type described in connection with FIGS. 1-7. During the operations of block 200, the switchable matching circuits 60-1 and 60-2 can be selectively switched into use based on whether Band_A and/or Band_B are active. The switchable matching circuits 60-1 and 60-2 can be adjusted by control signals output from transceiver 28, processing circuitry 26 (see FIG. 2), or other control circuitry within electronic device 10. If only Band_A is active, then only switchable matching circuit 60-1 will be switched into use (e.g., by activating switch 68-1 and deactivating switch 68-2). If only Band_B is active, then only switchable matching circuit 60-2 will be switched into use (e.g., by activating switch 68-2 and deactivating switch 68-1). If both Band_A and Band_B are active, then both switchable impedance matching circuits 60-1 and 60-2 can be switched into use (e.g., by activating both switches 68-1 and 68-2).

During the operations of block 202, the first lowpass-to-bandpass conversion filter 62-1 can be configured to filter received signals to produce a corresponding first filtered signal (e.g., a filtered signal in Band_A). The operations of block 202 can be performed in either the first mode or the third mode shown in FIG. 7. When operating the wireless circuitry in the second mode, the operations of block 202 can be bypassed or omitted since the first receive path will be switched out of use.

During the operations of block 204, the second lowpass-to-bandpass conversion filter 62-2 can be configured to filter received signals to produce a corresponding second filtered signal (e.g., a filtered signal in Band_B). The operations of block 204 can be performed in either the second mode or the third mode shown in FIG. 7. When operating the wireless circuitry in the first mode, the operations of block 204 can be bypassed or omitted since the second receive path will be switched out of use. Although the operations of block 204 are shown as occurring after block 202, the operations of block 202 and 204 can occur in parallel (simultaneously) when the wireless circuitry is operating in the third mode.

During the operations of block 206, frequency shifter 64 can optionally shift the frequency of the second filtered signal. Frequency shifter 64 can be configured to shift the second filtered signal from Band_B to Band_B', where Band_B' is closer to Band_A than Band_B. Doing so can reduce the wideband requirement of receiver 70, simplifying the receiver design, cost, and power consumption. The operations of block 206 can be omitted.

During the operations of block 208, combiner 66 can be configured to combine or merge the multiband signals received from the one or more receive paths. In the first mode, combiner 66 can receive only Band_A signals from first filter 62-1. In the second mode, combiner 66 can receive only Band_B (or optionally Band_B') signals from second filter 62-2. In the third mode, combiner 66 can receive both Band_A and Band_B (or optionally Band_B') signals from both the first filter 62-1 and second filter 62-2. Combiner 66 can output a signal to a receiving radio-frequency amplifier 52.

During the operations of block 210, radio-frequency amplifier 52 can be configured to amplify the signal receive from combiner 66. Amplifier 52 can output a corresponding amplified radio-frequency signal to transceiver 28 via a single (only one) receive path.

During the operations of block 212, wideband receiver 70 can be configured to downconvert, filter, and optionally convert the amplified signals to corresponding baseband signals. During the operations of block 214, circuit 72-1 can be configured to further filter and/or demodulate the baseband signals to produce corresponding signals associated with Band_A. During the operations of block 216, circuit 72-2 can be configured to further filter and/or demodulate the baseband signals to produce corresponding signals associated with Band_B. Although FIG. 8 shows block 216 are occurring after block 214, the operations of block 216 can occur in parallel (simultaneously) with the operations of block 214. The operations of block 214 can be omitted in the second mode since Band_A signals are absent in the second mode. The operations of block 216 can be omitted in the first mode since Band_B signals are absent in the first mode.

The operations of FIG. 8 are illustrative. In some embodiments, one or more of the described operations may be modified, replaced, or omitted. In some embodiments, one or more of the described operations may be performed in parallel. In some embodiments, additional processes may be added or inserted between the described operations. If desired, the order of certain operations may be reversed or altered and/or the timing of the described operations may be adjusted so that they occur at slightly different times. In some embodiments, the described operations may be distributed in a larger system.

The methods and operations described above in connection with FIGS. 1-8 may be performed by the components of device 10 using software, firmware, and/or hardware (e.g., dedicated circuitry or hardware). Software code for performing these operations may be stored on non-transitory computer readable storage media (e.g., tangible computer readable storage media) stored on one or more of the components of device 10 (e.g., storage circuitry 16 and/or wireless communications circuitry 24 of FIG. 1). The software code may sometimes be referred to as software, data, instructions, program instructions, or code. The non-transitory computer readable storage media may include drives, non-volatile memory such as non-volatile random-access memory (NVRAM), removable flash drives or other removable media, other types of random-access memory, etc. Software stored on the non-transitory computer readable storage media may be executed by processing circuitry on one or more of the components of device 10 (e.g., processing circuitry 26 in wireless circuitry 24, processing circuitry 18 of FIG. 1, etc.). The processing circuitry 26 may include microprocessors, application processors, digital signal processors, central processing units (CPUs), application-specific integrated circuits with processing circuitry, or other processing circuitry.

In accordance with an embodiment, circuitry includes a first filter circuit configured to output signals in a first frequency range, a second filter circuit configured to output signals in a second frequency range different than the first frequency range, a signal combiner having a first input coupled to the first filter circuit and having a second input coupled to the second filter circuit, and a first switchable matching circuit coupled to an input of the first filter circuit.

In accordance with another embodiment, the circuitry optionally includes a second switchable matching circuit coupled to an input of the second filter circuit.

In accordance with another embodiment, the first switchable matching circuit optionally includes a first switch that is selectively activated to couple the input of the first filter circuit to an antenna and selectively deactivated to disconnect the input of the first filter circuit from the antenna.

In accordance with another embodiment, the second switchable matching circuit optionally includes a second switch that is selectively activated to couple the input of the second filter circuit to the antenna and selectively deactivated to disconnect the input of the second filter circuit from the antenna.

In accordance with another embodiment, the first switchable matching circuit is optionally configured to provide a plurality of different impedances and the second switchable matching circuit is optionally configured to provide a plurality of different impedances.

In accordance with another embodiment, the circuitry optionally includes a frequency shifting circuit coupled between the second filter circuit and the second input of the signal combiner.

In accordance with another embodiment, the circuitry optionally includes only one radio-frequency amplifier coupled to an output of the signal combiner.

In accordance with another embodiment, the circuitry optionally includes a radio-frequency amplifier coupled to an output of the signal combiner and a receiver coupled to an output of the radio-frequency amplifier.

In accordance with another embodiment, the circuitry optionally includes a first circuit coupled to an output of the receiver and configured to output first baseband signals, where the first circuit optionally has a first bandwidth and the receiver optionally has a second bandwidth greater than the first bandwidth.

In accordance with another embodiment, the circuitry optionally includes a second circuit coupled to the output of the receiver and configured to output second baseband signals, where the second circuit optionally has a third bandwidth less than the second bandwidth of the receiver.

In accordance with another embodiment, the first filter circuit optionally includes a first active filter and the second filter circuit optionally includes a second active filter.

In accordance with another embodiment, the first filter circuit optionally includes a first lowpass-to-bandpass conversion filter and the second filter circuit optionally includes a second lowpass-to-bandpass conversion filter.

In accordance with another embodiment, the first filter circuit optionally includes a first N-path filter, the second filter circuit optionally includes a second N-path filter, and N is optionally an integer greater than two.

In accordance with another embodiment, the circuitry optionally includes a first switchable matching circuit coupled to an input of the first filter circuit, a second switchable matching circuit coupled to an input of the second filter circuit, and a control circuit for configuring the first and second switchable matching circuits to provide a target impedance to an antenna in a first mode, the target impedance to the antenna in a second mode different than the first mode, and the target impedance to the antenna in a third mode different than the first and second modes.

In accordance with another embodiment, during the first mode, the first switchable matching circuit is optionally activated while the second switchable matching circuit is deactivated.

**In** accordance with another embodiment, during the second mode, the second switchable matching circuit is optionally activated while the first switchable matching circuit is deactivated.

**In** accordance with another embodiment, during the third mode, the first and second switchable matching circuits are optionally activated.

**In** accordance with an embodiment, circuitry includes a first impedance matching circuit configured to receive a radio-frequency signal, a second impedance matching circuit configured to receive the radio-frequency signal, and a combiner having a first input coupled to the first impedance matching circuit and having a second input coupled to the second impedance matching circuit, where the first input of the combiner is configured to receive a first signal associated with a first frequency band. and the second input of the combiner is configured to receive a second signal associated with a second frequency band different than the first frequency band.

In accordance with another embodiment, the circuitry optionally includes a first lowpass-to-bandpass conversion filter coupled between the first impedance matching circuit and the first input of the combiner and a second lowpass-to-bandpass conversion filter coupled between the second impedance matching circuit and the second input of the combiner.

In accordance with an embodiment, circuitry includes a first switchable matching circuit selectively coupled to an antenna, a second switchable matching circuit selectively coupled to the antenna, a first active filter coupled to the first switchable matching circuit, a second active filter coupled to the second switchable matching circuit, a signal combiner having a first terminal coupled to the first active filter, a second terminal coupled to the second active filter, and a third terminal, and a radio-frequency amplifier coupled to the third terminal of the signal combiner.

In accordance with an embodiment, a method of operating wireless circuitry includes with a first lowpass-to-bandpass conversion filter, outputting a first signal in a first frequency range, with a second lowpass-to-bandpass conversion filter, outputting a second signal in a second frequency range different than the first frequency range, and with a combiner, receiving the first signal from the first lowpass-to-bandpass conversion filter and the second signal from the second lowpass-to-bandpass conversion filter.

In accordance with another embodiment, the method optionally includes with a first matching circuit, coupling the first filter to an antenna and with a second matching circuit, coupling the second filter to the antenna.

In accordance with another embodiment, the method optionally includes activating a first switch of the first matching circuit to couple the first filter to the antenna.

In accordance with another embodiment, the method optionally includes deactivating the first switch of the first matching circuit to decouple the first filter from the antenna.

In accordance with another embodiment, the method optionally includes activating a second switch of the second matching circuit to couple the second filter to the antenna and deactivating the second switch of the second matching circuit to decouple the second filter from the antenna.

In accordance with another embodiment, the method optionally includes during a first mode, activating the first switch while deactivating the second switch, and during a second mode different than the first mode, activating the second switch while deactivating the first switch.

In accordance with another embodiment, the method optionally includes during a third mode different than the first and second modes, activating the first switch and the second switch.

In accordance with another embodiment, the method optionally includes configuring the first matching circuit to provide a first impedance during the first mode, and configuring the second matching circuit to provide a second impedance equal to the first impedance during the second mode.

In accordance with another embodiment, the method optionally includes configuring the first matching circuit to provide a third impedance different than the first impedance during the third mode and configuring the second matching circuit to provide a fourth impedance equal to the third impedance during the third mode.

In accordance with another embodiment, the method optionally includes with a frequency shifter, shifting the second signal from the second frequency range to a third frequency range that is closer to the first frequency range.

In accordance with another embodiment, the method optionally includes with the combiner, outputting signals to only one radio-frequency amplifier.

In accordance with another embodiment, the method optionally includes with the combiner, outputting signals to a radio-frequency amplifier and with a receiver circuit have a first bandwidth, receiving signals from the radio-frequency amplifier, with the first mixer and filter circuit, receiving signals from the receiver circuit and outputting a first baseband signal, and with the second mixer and filter circuit, receiving signals from the receiver circuit and outputting a second baseband signal.

In accordance with another embodiment, the first mixer and filter circuit optionally has a second bandwidth less than the first bandwidth, and where the second mixer and filter circuit optionally has a third bandwidth less than the first bandwidth.

In accordance with an embodiment, a method of operating wireless circuitry includes during a first mode, configuring a first switchable matching circuit to provide a first impedance to an antenna, during a second mode, configuring a second switchable matching circuit to provide a second impedance to the antenna, and with a combiner, receiving a first filtered signal generated based on a signal received through the first switchable matching circuit and receiving a second filtered signal generated based on a signal received through the second switchable matching circuit.

In accordance with another embodiment, the method optionally includes during a third mode, configuring the first switchable matching circuit to provide a third impedance, greater than the first impedance, to the antenna, and during the third mode, configuring the second switchable matching circuit to provide a fourth impedance, greater than the second impedance, to the antenna.

In accordance with another embodiment, the third impedance is optionally equal to the fourth impedance.

In accordance with another embodiment, the method optionally includes with a first filter coupled to the first switchable matching circuit, outputting the first filtered signal, and with a second filter coupled to the second switchable matching circuit, outputting the second filtered signal.

In accordance with another embodiment, the first filter optionally includes a first lowpass-to-bandpass conversion filter and where the second filter optionally includes a second lowpass-to-bandpass conversion filter.

In accordance with another embodiment, the method optionally includes with a frequency shifter coupled between the second filter and the combiner, shifting a frequency of the second filtered signal.

In accordance with an embodiment, wireless circuitry includes a first matching circuit configured to provide one or more impedance values, a second matching circuit configured to provide one or more impedance values, a first means for filtering signals from the first matching circuit, a second means for filtering signals from the second matching circuit, and a third means for combining signals from the first and second means.

The foregoing is merely illustrative and various modifications can be made to the described embodiments. The foregoing embodiments may be implemented individually or in any combination.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

Exemplary embodiments are set out in the following items and articles:

### items

1. Circuitry comprising:
   a first filter circuit configured to output signals in a first frequency range;
   a second filter circuit configured to output signals in a second frequency range different than the first frequency range;
   a signal combiner having a first input coupled to the first filter circuit and having a second input coupled to the second filter circuit; and
   a first switchable matching circuit coupled to an input of the first filter circuit.
2. The circuitry of item 1, further comprising:
   a second switchable matching circuit coupled to an input of the second filter circuit.
3. The circuitry of any of items 1-2, wherein the first switchable matching circuit comprises a first switch that is selectively activated to couple the input of the first filter circuit to an antenna and selectively deactivated to disconnect the input of the first filter circuit from the antenna.
4. The circuitry of any of items 2-3, wherein the second switchable matching circuit comprises a second switch that is selectively activated to couple the input of the second filter circuit to the antenna and selectively deactivated to disconnect the input of the second filter circuit from the antenna.
5. The circuitry of any of items 2-4, wherein the first switchable matching circuit is configured to provide a plurality of different impedances and wherein the second switchable matching circuit is configured to provide a plurality of different impedances.
6. The circuitry of any of items 1-5, further comprising:
   a frequency shifting circuit coupled between the second filter circuit and the second input of the signal combiner.
7. The circuitry of any of items 1-6, further comprising:
   only one radio-frequency amplifier coupled to an output of the signal combiner.
8. The circuitry of any of items 1-7, further comprising:
   a radio-frequency amplifier coupled to an output of the signal combiner; and
   a receiver coupled to an output of the radio-frequency amplifier.
9. The circuitry of item 8, further comprising:
   a first circuit coupled to an output of the receiver and configured to output first baseband signals, wherein the first circuit has a first bandwidth and wherein the receiver has a second bandwidth greater than the first bandwidth.
10. The circuitry of item 9, further comprising:
   a second circuit coupled to the output of the receiver and configured to output second baseband signals, wherein the second circuit has a third bandwidth less than the second bandwidth of the receiver.
11. The circuitry of any of items 1-10, wherein the first filter circuit comprises a first active filter and wherein the second filter circuit comprises a second active filter.
12. The circuitry of any of items 1-11, wherein the first filter circuit comprises a first lowpass-to-bandpass conversion filter and wherein the second filter circuit comprises a second lowpass-to-bandpass conversion filter.
13. The circuitry of any of items 1-12, wherein the first filter circuit comprises a first N-path filter, wherein the second filter circuit comprises a second N-path filter, and wherein N is an integer greater than two.
14. The circuitry of any of items 1-13, further comprising:
   a first switchable matching circuit coupled to an input of the first filter circuit;
   a second switchable matching circuit coupled to an input of the second filter circuit; and
   a control circuit for configuring the first and second switchable matching circuits to provide a target impedance to an antenna in a first mode, the target impedance to the antenna in a second mode different than the first mode, and the target impedance to the antenna in a third mode different than the first and second modes.
15. The circuitry of item 14, wherein during the first mode, the first switchable matching circuit is activated while the second switchable matching circuit is deactivated.
16. The circuitry of item 15, wherein during the second mode, the second switchable matching circuit is activated while the first switchable matching circuit is deactivated.
17. The circuitry of item 16, wherein during the third mode, the first and second switchable matching circuits are activated.
18. Circuitry comprising:
   a first impedance matching circuit configured to receive a radio-frequency signal;
   a second impedance matching circuit configured to receive the radio-frequency signal; and
   a combiner having a first input coupled to the first impedance matching circuit and having a second input coupled to the second impedance matching circuit, wherein:
      the first input of the combiner is configured to receive a first signal associated with a first frequency band; and
      the second input of the combiner is configured to receive a second signal associated with a second frequency band different than the first frequency band.
19. The circuitry of item 18, further comprising:
   a first lowpass-to-bandpass conversion filter coupled between the first impedance matching circuit and the first input of the combiner; and
   a second lowpass-to-bandpass conversion filter coupled between the second impedance matching circuit and the second input of the combiner.
20. Circuitry comprising:
   a first switchable matching circuit selectively coupled to an antenna;
   a second switchable matching circuit selectively coupled to the antenna;
   a first active filter coupled to the first switchable matching circuit;
   a second active filter coupled to the second switchable matching circuit;
   a signal combiner having a first terminal coupled to the first active filter, a second terminal coupled to the second active filter, and a third terminal; and
   a radio-frequency amplifier coupled to the third terminal of the signal combiner.

### articles

1. A method of operating wireless circuitry, comprising:
   with a first lowpass-to-bandpass conversion filter, outputting a first signal in a first frequency range;
   with a second lowpass-to-bandpass conversion filter, outputting a second signal in a second frequency range different than the first frequency range; and
   with a combiner, receiving the first signal from the first lowpass-to-bandpass conversion filter and the second signal from the second lowpass-to-bandpass conversion filter.
2. The method of article 1, further comprising:
   with a first matching circuit, coupling the first filter to an antenna; and
   with a second matching circuit, coupling the second filter to the antenna.
3. The method of article 2, further comprising:
   activating a first switch of the first matching circuit to couple the first filter to the antenna.
4. The method of article 3, further comprising:
   deactivating the first switch of the first matching circuit to decouple the first filter from the antenna.
5. The method of any of articles 1-4, further comprising:
   activating a second switch of the second matching circuit to couple the second filter to the antenna; and
   deactivating the second switch of the second matching circuit to decouple the second filter from the antenna.
6. The method of article 5, further comprising:
   during a first mode, activating the first switch while deactivating the second switch; and
   during a second mode different than the first mode, activating the second switch while deactivating the first switch.
7. The method of article 6, further comprising:
   during a third mode different than the first and second modes, activating the first switch and the second switch.
8. The method of any of articles 6-7, further comprising:
   configuring the first matching circuit to provide a first impedance during the first mode; and
   configuring the second matching circuit to provide a second impedance equal to the first impedance during the second mode.
9. The method of article 8, further comprising:
   configuring the first matching circuit to provide a third impedance different than the first impedance during the third mode; and
   configuring the second matching circuit to provide a fourth impedance equal to the third impedance during the third mode.
10. The method of any of articles 1-9, further comprising:
   with a frequency shifter, shifting the second signal from the second frequency range to a third frequency range that is closer to the first frequency range.
11. The method of any of articles 1-10, further comprising:
   with the combiner, outputting signals to only one radio-frequency amplifier.
12. The method of any of articles 1-11, further comprising:
   with the combiner, outputting signals to a radio-frequency amplifier; and
   with a receiver circuit have a first bandwidth, receiving signals from the radio-frequency amplifier;
   with the first mixer and filter circuit, receiving signals from the receiver circuit and outputting a first baseband signal; and
   with the second mixer and filter circuit, receiving signals from the receiver circuit and outputting a second baseband signal.
13. The method of article 12, wherein the first mixer and filter circuit has a second bandwidth less than the first bandwidth, and wherein the second mixer and filter circuit has a third bandwidth less than the first bandwidth.
14. A method of operating wireless circuitry, comprising:
   during a first mode, configuring a first switchable matching circuit to provide a first impedance to an antenna;
   during a second mode, configuring a second switchable matching circuit to provide a second impedance to the antenna; and
   with a combiner, receiving a first filtered signal generated based on a signal received through the first switchable matching circuit and receiving a second filtered signal generated based on a signal received through the second switchable matching circuit.
15. The method of article 14, further comprising:
   during a third mode, configuring the first switchable matching circuit to provide a third impedance, greater than the first impedance, to the antenna; and
   during the third mode, configuring the second switchable matching circuit to provide a fourth impedance, greater than the second impedance, to the antenna.
16. The method of article 15, wherein the third impedance is equal to the fourth impedance.
17. The method of any of articles 15-16, further comprising:
   with a first filter coupled to the first switchable matching circuit, outputting the first filtered signal; and
   with a second filter coupled to the second switchable matching circuit, outputting the second filtered signal.
18. The method of article 17, wherein the first filter comprises a first lowpass-to-bandpass conversion filter and wherein the second filter comprises a second lowpass-to-bandpass conversion filter.
19. The method of article 18, further comprising:
   with a frequency shifter coupled between the second filter and the combiner, shifting a frequency of the second filtered signal.
20. Wireless circuitry comprising:
   a first matching circuit configured to provide one or more impedance values;
   a second matching circuit configured to provide one or more impedance values;
   a first means for filtering signals from the first matching circuit;
   a second means for filtering signals from the second matching circuit; and
   a third means for combining signals from the first and second means.

## Claims

1. Circuitry comprising:
a first filter circuit configured to output signals in a first frequency range;
a second filter circuit configured to output signals in a second frequency range different than the first frequency range;
a signal combiner having a first input coupled to the first filter circuit and having a second input coupled to the second filter circuit; and
a first switchable matching circuit coupled to an input of the first filter circuit.

2. The circuitry of claim 1, further comprising:
a second switchable matching circuit coupled to an input of the second filter circuit.

3. The circuitry of any of claims 1-2, wherein the first switchable matching circuit comprises a first switch that is selectively activated to couple the input of the first filter circuit to an antenna and selectively deactivated to disconnect the input of the first filter circuit from the antenna.

4. The circuitry of any of claims 2-3, wherein the second switchable matching circuit comprises a second switch that is selectively activated to couple the input of the second filter circuit to the antenna and selectively deactivated to disconnect the input of the second filter circuit from the antenna.

5. The circuitry of any of claims 2-4, wherein the first switchable matching circuit is configured to provide a plurality of different impedances and wherein the second switchable matching circuit is configured to provide a plurality of different impedances.

6. The circuitry of any of claims 1-5, further comprising:
a frequency shifting circuit coupled between the second filter circuit and the second input of the signal combiner.

7. The circuitry of any of claims 1-6, further comprising:
only one radio-frequency amplifier coupled to an output of the signal combiner.

8. The circuitry of any of claims 1-7, further comprising:
a radio-frequency amplifier coupled to an output of the signal combiner; and
a receiver coupled to an output of the radio-frequency amplifier.

9. The circuitry of claim 8, further comprising:
a first circuit coupled to an output of the receiver and configured to output first baseband signals, wherein the first circuit has a first bandwidth and wherein the receiver has a second bandwidth greater than the first bandwidth.

10. The circuitry of claim 9, further comprising:
a second circuit coupled to the output of the receiver and configured to output second baseband signals, wherein the second circuit has a third bandwidth less than the second bandwidth of the receiver.

11. The circuitry of any of claims 1-10, wherein the first filter circuit comprises a first active filter and wherein the second filter circuit comprises a second active filter.

12. The circuitry of any of claims 1-11, wherein the first filter circuit comprises a first lowpass-to-bandpass conversion filter and wherein the second filter circuit comprises a second lowpass-to-bandpass conversion filter.

13. The circuitry of any of claims 1-12, wherein the first filter circuit comprises a first N-path filter, wherein the second filter circuit comprises a second N-path filter, and wherein N is an integer greater than two.

14. The circuitry of any of claims 1-13, further comprising:
a first switchable matching circuit coupled to an input of the first filter circuit;
a second switchable matching circuit coupled to an input of the second filter circuit; and
a control circuit for configuring the first and second switchable matching circuits to provide a target impedance to an antenna in a first mode, the target impedance to the antenna in a second mode different than the first mode, and the target impedance to the antenna in a third mode different than the first and second modes.

15. The circuitry of claim 14, wherein during the first mode, the first switchable matching circuit is activated while the second switchable matching circuit is deactivated, wherein during the second mode, the second switchable matching circuit is activated while the first switchable matching circuit is deactivated, wherein during the third mode, the first and second switchable matching circuits are activated.
